(19) **Europäisches Patentamt**

**European Patent Office**

**Office européen des brevets**

(11) **EP 0 660 512 B1**

(12) **FASCICULE DE BREVET EUROPEEN**

(45) Date de publication et mention
de la délivrance du brevet:
**08.12.1999 Bulletin 1999/49**

(51) Int Cl.⁶: **H03H 11/22**

(21) Numéro de dépôt: **94203607.0**

(22) Date de dépôt: **13.12.1994**

(54) **Amplificateur déphaseur et son application à un circuit recombineur**

Phasenschiebverstärker und seine Verwendung in einer Zusammenführungsschaltung

Phase shifter amplifier and its application in a recombiner circuit

(84) Etats contractants désignés:
**DE FR GB**

(30) Priorité: **22.12.1993 FR 9315461**

(43) Date de publication de la demande:
**28.06.1995 Bulletin 1995/26**

(73) Titulaires:
- **PHILIPS COMPOSANTS ET
  SEMICONDUCTEURS
  92150 Suresnes (FR)**
  Etats contractants désignés:
  **FR**
- **Koninklijke Philips Electronics N.V.
  5621 BA Eindhoven (NL)**
  Etats contractants désignés:
  **DE GB**

(72) Inventeur: **Drogi, Serge
F-75008 Paris (FR)**

(74) Mandataire: **Charpail, François et al
Société Civile S.P.I.D.
156, Boulevard Haussmann
75008 Paris (FR)**

(56) Documents cités:
**EP-A- 0 302 290        WO-A-91/10286
WO-A-92/11704**

## Description

L'invention concerne un amplificateur déphaseur comprenant un premier et un deuxième transistors agencés pour former une paire différentielle d'entrée alimentée à courant constant, ces transistors ayant chacun une électrode de commande recevant un signal d'entrée, ainsi qu'une électrode de sortie, amplificateur dans lequel l'électrode de sortie du premier transistor est connectée à une borne d'une première résistance de déphasage ainsi qu'à une borne d'une première capacité de déphasage, l'électrode de sortie du deuxième transistor est connectée à une borne d'une deuxième résistance de déphasage ainsi qu'à une borne d'une deuxième capacité de déphasage, l'autre borne de la première résistance de déphasage est connectée à l'autre borne de la deuxième capacité de déphasage en un premier noeud, et l'autre borne de la deuxième résistance de déphasage est connectée à l'autre borne de la première capacité de déphasage en un deuxième noeud.

L'invention concerne également un circuit recombineur effectuant pour chacun de deux signaux différentiels d'entrée, déphasés l'un par rapport à l'autre, une amplification et une sommation de ces signaux après un déphasage complémentaire, l'un des signaux d'entrée présentant une première composante de phase déterminée et l'autre signal d'entrée présentant une deuxième composante en quadrature avec la première composante.

Les amplificateurs déphaseurs sont de nos jours utilisés dans de nombreuses applications et particulièrement dans le domaine des transmissions radiofréquences. Une application typique consiste à produire deux signaux en quadrature en vue de leur codage à l'émission. Un deuxième exemple particulièrement important d'utilisation d'amplificateurs déphaseurs en ce qui concerne la réception consiste à réaliser un mélangeur utilisant deux amplificateurs déphaseurs permettant, lorsque le déphasage en quadrature est idéalement respecté, d'éliminer la fréquence image dans un récepteur superhétérodyne.

Un amplificateur déphaseur du type défini dans le paragraphe introductif est connu du document WO-A-9211704 où il y est plus particulièrement décrit en liaison avec la figure 2 de ce document. L'amplificateur déphaseur connu utilise des réseaux de type RC série connectés en parallèle entre les électrodes de sortie des transistors de l'étage d'entrée. Cet amplificateur fonctionne essentiellement en tension du fait que des branches résistance de déphasage-condensateur de déphasage, fournissent en leur point intermédiaire un signal sous forme de tension de sortie pour une utilisation à haute impédance d'entrée.

En effet, l'impédance d'utilisation influe sur le déphasage des signaux de sortie lorsqu'elle n'est pas très grande devant l'impédance des éléments du réseau RC. Ceci représente un inconvénient sérieux du point de vue de la consommation de courant. En effet, pour conserver un rapport signal/bruit élevé à la sortie de l'amplificateur déphaseur, il est nécessaire de l'alimenter à courant relativement élevé. Mais en sortie de l'amplificateur déphaseur, un amplificateur de puissance est nécessaire lequel doit également être alimenté à courant élevé, pour la même raison.

L'invention se propose de remédier à cet inconvénient en fournissant un amplificateur déphaseur performant du point de vue du rapport signal/bruit faisant l'économie d'une amplification ultérieure en puissance et réduisant d'autant la consommation de courant d'alimentation.

L'invention se base sur l'idée de faire fonctionner le réseau de déphasage de type RC dans un mode admittance plutôt que dans un mode impédance, le mode admittance fournissant une sortie de signal en puissance plutôt qu'en tension. Cette idée a été appliquée dans d'autres types d'amplificateurs déphaseurs. Par exemple le circuit de la ligne 4 de EP-A-302 290 se distingue de la présente invention par le fait qu'il n'utilise pas de paire différentielle d'entrée alimentée à courant constant: il utilise, à la place, des amplificateurs suiveurs de tension, qui ont donc une impédance de sortie beaucoup plus basse et donc à priori mieux adaptée à la basse impédance d'entrée des amplificateurs transimpédance extrayant le signal du réseau déphaseur.

En effet, selon la présente invention, un amplificateur déphaseur du type cité dans le paragraphe introductif est caractérisé en ce que le premier noeud est connecté à l'entrée d'un amplificateur de type transimpédance et le deuxième noeud est connecté à l'entrée d'un autre amplificateur de type transimpédance, lesquels amplificateurs délivrent un signal différentiel de sortie déphasé par rapport au signal d'entrée.

Un signal différentiel, déphasé par rapport au signal d'entrée, apparaît en sortie des amplificateurs à transimpédance. Ce signal peut être utilisé ensuite sous une impédance dont la valeur n'exerce aucune influence sur la valeur du déphasage de ces signaux. L'amplificateur déphaseur selon l'invention offre l'avantage d'une impédance de sortie relativement basse permettant une sortie performante du point de vue du rapport signal/bruit étant donné que les pertes dans les réseaux RC (résistance de déphasage, capacité de déphasage) sont très faibles. Ainsi la puissance du signal amplifié est disponible en sortie sans nécessité d'utiliser un étage supplémentaire d'amplification en puissance. Il s'en suit une économie correspondante du point de vue de la circuiterie ainsi que de la consommation de courant d'alimentation.

Selon un mode de mise en oeuvre préféré pour sa simplicité, l'amplificateur déphaseur est caractérisé en ce que les amplificateurs de type transimpédance sont constitués par un étage cascode formé par un troisième, respectivement un quatrième transistors, dont les électrodes de sortie sont couplées respectivement à une première et à une deuxième résistance de charge et dont les électrodes de commande reçoivent une tension de référence.

Pour permettre un ajustement de la phase des signaux de sortie, une variante de réalisation de l'invention est caractérisée en ce que l'amplificateur déphaseur comporte au moins une résistance de déphasage additionnelle, susceptible d'être connectée en parallèle sur la résistance de déphasage au moyen d'un interrupteur électronique.

Avantageusement les premier, deuxième, troisième et quatrième transistors sont des transistors bipolaires tandis que ledit interrupteur électronique est constitué par un transistor à effet de champ de type MOS.

Comme il sera expliqué plus en détail dans ce qui suit, le calcul du déphasage d'un signal de fréquence déterminée est suffisamment simple pour qu'on puisse prévoir aisément les valeurs des résistances de déphasage additionnelles permettant d'obtenir un déphasage déterminé (par exemple de 90°) en sortie, par rapport au signal d'entrée, en fonction de diverses fréquences du signal d'entrée.

Une application particulièrement avantageuse de l'amplificateur déphaseur selon l'invention concerne un circuit recombineur effectuant pour chacun de deux signaux différentiels d'entrée, déphasés l'un par rapport à l'autre, une amplification et une sommation de ces signaux après un déphasage complémentaire, l'un des signaux d'entrée présentant une première composante de phase déterminée et l'autre signal d'entrée présentant une deuxième composante en quadrature avec la première composante, caractérisé en ce que ce circuit recombineur est constitué de deux amplificateurs déphaseurs tels que définis précédemment.

Un tel circuit recombineur est particulièrement adapté à recevoir des signaux d'entrée en courant et fournit à sa sortie des signaux de sortie en puissance présentant un rapport signal/bruit très performant sans qu'il soit besoin de prévoir un étage d'amplification supplémentaire comme c'est le cas d'un circuit recombineur connu.

La description qui va suivre en regard des dessins annexés, donnés à titre d'exemples non limitatifs, fera bien comprendre en quoi consiste l'invention et comment elle peut être réalisée.

La figure 1 montre le schéma électrique d'un amplificateur déphaseur selon l'invention.

La figure 2 est un schéma de principe d'un circuit déphaseur connu, tandis que

la figure 3 montre par comparaison avec la figure 2, un schéma de principe du circuit déphaseur selon l'invention.

La figure 4 donne un schéma par bloc, avec lequel une application de l'invention à un appareil de réception radiofréquence sera précisée,

la figure 5 donne le schéma électrique d'un circuit recombineur utilisant deux amplificateurs déphaseurs de l'invention.

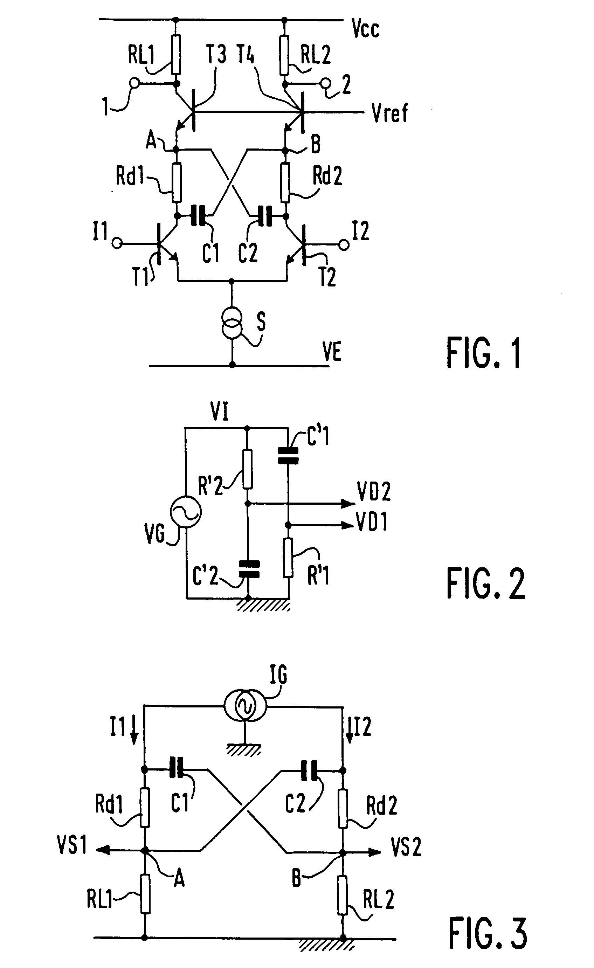

L'amplificateur déphaseur de la figure 1 comprend une paire différentielle de transistors bipolaires de type NPN formée d'un premier transistor T1 et d'un deuxième transistor T2, alimentée à courant constant au moyen d'une source de courant S qui est connectée d'une part aux émetteurs réunis des transistors T1 et T2 et d'autre part, à une borne d'alimentation négative VE de l'amplificateur. La base du transistor T1 reçoit un signal d'entrée I1 tandis que la base du transistor T2 reçoit un signal d'entrée I2, inverse du signal I1. Le collecteur du transistor T1 est connecté d'une part à une première résistance de déphasage Rd1 et d'autre part à une première capacité de déphasage C1. De façon similaire, le collecteur du transistor T2 est connecté d'une part à une deuxième résistance de déphasage Rd2 et d'autre part à une deuxième capacité de déphasage C2. L'autre borne de la résistance de déphasage Rd1, forme un noeud A, l'autre borne de la résistance de déphasage Rd2 forme un noeud B, noeuds auxquels sont connectés en couplage croisé l'autre borne des capacités de déphasage C1 et C2. Une première résistance de charge RL1 est couplée au noeud A et une deuxième résistance de charge RL2 est couplée au noeud B via un étage cascode formé d'un troisième transistor T3 et d'un quatrième transistor T4 de type NPN, dont les bases sont interconnectées et reçoivent une tension de référence Vref. L'émetteur du transistor T3 est connecté au noeud A son collecteur connecté à la première résistance de charge RL1, et l'émetteur du transistor T4 est connecté au noeud B et son collecteur connecté à la deuxième résistance de charge RL2. Les résistances RL1 et RL2 sont par ailleurs connectées à une borne d'alimentation positive Vcc.

La tension aux noeuds A et B est pratiquement fixe puisqu'elle est imposée à 1 VBE près par la tension Vref. L'impédance vue du noeud A en direction de la résistance de charge RL1 peut être rendue très faible vis-à-vis de la première résistance de déphasage Rd1 par le choix du courant débité par la source de courant S. Il en va de même pour l'impédance vue du noeud B en direction de la deuxième résistance de charge RL2.

Ainsi, l'étage cascode T3, T4, muni des résistances de charge RL1 et RL2 constitue-t-il un amplificateur de type transimpédance, ici très simplifié, puisque, ce sont essentiellement des signaux en courant qui sont transmis aux résistances de charge RL1 et RL2, lesquelles développent une tension de sortie. En effet, une première borne de sortie 1 de l'amplificateur est connectée au noeud rejoignant le collecteur du transistor T3 à la résistance de charge RL1, tandis qu'une deuxième borne de sortie 2 est connectée au noeud reliant le collecteur du transistor T4 à la résistance de charge RL2.

Il est clair que l'amplificateur déphaseur ainsi décrit a la propriété de fournir un signal différentiel de sortie sur les bornes 1 et 2 qui est un signal en puissance du point de vue alternatif. L'impédance d'entrée d'un circuit d'utilisation relié aux bornes de sortie 1 et 2 n'influe pas sur la valeur du déphasage obtenue avec les signaux de sortie sur ces bornes. Cette propriété de l'amplificateur représenté est particulièrement avantageuse du point de vue du bruit du signal de sortie. Le bruit peut être facilement optimisé en fonction des paramètres du circuit, notamment le courant débité par la source de courant S.

Une analyse plus détaillée du fonctionnement de l'amplificateur déphaseur de l'invention et une comparaison avec un circuit déphaseur connu vont être maintenant entreprises à l'aide des figures 2 et 3.

La figure 2 montre le principe d'un circuit déphaseur connu. Un générateur VG fournit un signal de tention VI par rapport à la masse, qui est appliqué à 2 branches en parallèle, la première branche comportant successivement une capacité de déphasage C'1 et une résistance de déphasage R'1 et la deuxième branche, successivement, une résistance de déphasage R'2 et une capacité de déphasage C'2. Dans chacune des deux branches, le réseau de déphasage est donc d'un type RC en série. Des tensions de sortie VD1 et VD2 sont prélevées aux points intermédiaires des éléments de chacune des branches. Un circuit de ce type présente un inconvénient majeur en ce que les signaux de sortie VD1 et VD2, déphasés l'un par rapport à l'autre, nécessitent une amplification en puissance sous une forte impédance d'entrée faute de quoi le déphasage de ces signaux serait perturbé. Du point de vue du rapport signal/bruit, que l'on s'efforce de maintenir le plus élevé possible, il y a donc lieu de prévoir des impédances relativement faibles dans le circuit de déphasage ce qui implique d'utiliser des courants relativement élevés. Mais il faut ajouter à la sortie un amplificateur de puissance, lui aussi à forte consommation, pour maintenir ce rapport signal/bruit dans des limites requises.

Selon la figure 3, au contraire, un générateur de signal IG fournit par rapport à la masse deux signaux complémentaires I1, I2, signaux qui sont maintenant essentiellement, des signaux en courant. Le signal I1 est débité dans une résistance de déphasage Rd1 ainsi que dans une capacité de déphasage C1, la résistance Rd1 étant par ailleurs connectée à un noeud A.

Le signal I2 est, quant à lui, débité dans une résistance de déphasage Rd2 ainsi que dans une capacité de déphasage C2, la résistance Rd2 étant connectée par ailleurs au noeud B. Entre le noeud A et la masse, d'une part et entre le noeud B et la masse d'autre part, sont insérés des résistances de charge RL1 et RL2. Les capacités C1 et C2 sont connectées en couplage croisé entre les bornes des résistances Rd1 et Rd2. Ainsi, le circuit de la figure 3, reprend le principe de l'amplificateur déphaseur décrit à la figure 1. Idéalement les résistances de charge RL1 et RL2 devraient avoir une valeur nulle. En pratique il suffit que la valeur de ces résistances de charge soit très inférieure aux résistances de déphasage Rd1 et Rd2. Les signaux de sortie VS1 et VS2 apparaissant respectivement sur les noeuds A et B sont toutefois d'autant moins élevés en tension que les résistances de charge RL1 et RL2 sont plus petites. En se reportant à nouveau au schéma de la figure 1, cette limitation en tension n'existe plus du fait de la présence de l'étage cascode formé des transistors T3 et T4.

Il en va de même lorsque l'étage cascode est remplacée par des amplificateurs du type transimpédance, indépendamment de leur mode de construction.

Les signaux de sortie sur les bornes 1 et 2 du circuit de la figure 1 peuvent être amplifiés en tension en choisissant des résistances RL1 et RL2 d'une valeur aussi élevée qu'on le désire, qui soit cependant compatible avec le courant délivré par la source de courant S, la valeur de Vcc, et compte tenu de l'excursion prévue pour le signal différentiel d'entrée I1, I2.

Il est bien connu que les signaux de sortie Vd1 et Vd2 du déphaseur de la figure 2 présentent entre eux un déphasage dépendant de la fréquence et des valeurs de résistances de déphasage et de capacité de déphasage, déphasage qui peut être déterminé aisément à la condition que ces signaux soient utilisés sous une impédance pratiquement infinie, ou, en tout cas, très élevée devant l'impédance des éléments des réseaux RC.

Dans le circuit déphaseur de la figure 3, les signaux de sortie VS1 et VS2 restent opposés l'un de l'autre et présentent un déphasage identique par rapport à la phase des signaux d'entrée I1 et I2.

Par une analyse mathématique classique, on peut montrer que la valeur du déphasage ($\varphi$) des signaux VS1 et VS2 par rapport à I1 et I2, respectivement, est égal à :

$$\varphi = -2.\text{Arctg}(R.C.\omega)$$

lorsque la valeur des résistance Rd1 et Rd2 est égale, notée R, la valeur des capacités C1 et C2 est égale, et notée C, expression dans laquelle $\omega = 2\pi F$, où F est la fréquence du signal considéré.

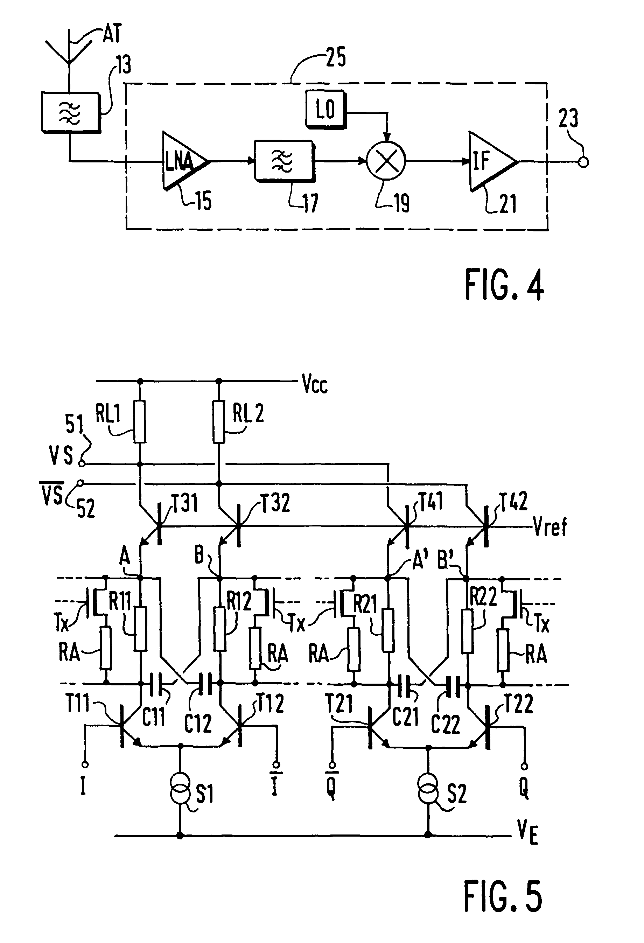

L'amplificateur déphaseur selon l'invention peut être utilisé dans de nombreuses applications. A titre d'exemple, une application à la partie réception d'un appareil de communication radio-fréquence va être brièvement décrite en regard de la figure 4.

La figure 4 présente très schématiquement une portion de la voie de réception d'un appareil de communication, qui comporte, classiquement, un premier filtre passe-bande 13 recevant les signaux d'antenne AT pour une sélection grossière de la bande de fréquence à recevoir, un amplificateur à faible bruit 15 (LNA) un deuxième filtre passe-bande 17 au moyen duquel on cherche principalement à effectuer une pré-sélection du canal (des canaux) à recevoir tout en atténuant le plus possible la fréquence image, c'est-à-dire la fréquence symétrique de la fréquence à recevoir par rapport à la fréquence d'un oscillateur local L0. Le signal de cet oscillateur L0 est combiné par multiplication avec le signal de réception dans un multiplieur 19 à la sortie duquel est disposé un amplificateur de fréquences intermédiaires 21 (IF).

Pour des raisons pratiques et économiques il est souhaitable d'intégrer dans un même circuit semiconducteur, la portion entourée sur la figure d'un cadre en tirets 25, à savoir l'amplificateur à faible bruit 15, le filtre passe bande 17, l'oscillateur local L0, le circuit multiplieur 19 et l'amplificateur de fréquence intermédiaire 21. Un tel circuit intégré 25 reçoit donc les signaux d'antenne après un premier filtre 13 et délivre un signal à fréquence intermédiaire amplifié à la borne de sortie 23.

Vu les caractéristiques très particulières demandées au filtre passe-bande 17, ce filtre était le plus souvent extérieur au circuit intégré 25, ce filtre étant alors constitué, par exemple, selon une technique dite à ondes de surface, ce qui présente l'inconvénient d'un prix élevé et d'un encombrement important dans l'appareil. Une solution susceptible d'être intégrée consiste à utiliser une autre technique basée sur l'addition de composantes du signal à filtrer, déphasées en quadrature. Une telle technique est connue dans son principe et a déjà été proposée pour effectuer la réjection de la fréquence image, symétrique de la fréquence à recevoir, par rapport à la fréquence d'un oscillateur local.

Une réjection d'image de ce type est utilisée par exemple dans le circuit portant la référence UAA2072M, commercialisé par la société PHILIPS.

Toutefois, ce circuit applique le principe du circuit déphaseur décrit à la figure 2, qui présente l'inconvénient d'une consommation élevée en courant d'alimentation comme cela à été expliqué précédemment, consommation qui est d'autant plus gênante lorsqu'on destine ce circuit à un appareil portatif, fonctionnant sur piles.

La figure 5 montre le schéma d'un circuit recombineur permettant d'intégrer facilement les fonctions du circuit 25 de la figure 4 avec une économie de moyens en ce qui concerne les composants et résultant en une réduction substantielle du courant d'alimentation nécessaire.

On reconnaît aisément à la figure 5 un premier amplificateur déphaseur constitué par les transistors T11, T12, la source de courant S1, les résistances de déphasage R11, R12, les capacités de déphasage C11, C12, un étage cascode formé des transistors T31, T32, et deux résistances de charge RL1 et RL2. Le deuxième amplificateur déphaseur est constitués des transistors d'entrée T21, T22, de la source de courant S2, des résistances de déphasage R21, R22, des capacités de déphasage C21, C22, d'une paire de transistors cascodes T41, T42, le collecteur de ces transistors étant couplé aux mêmes résistances de charge RL1, RL2, les deux amplificateurs déphaseurs effectuant par conséquent une recombinaison de signaux sur ces résistances communes. Les étages cascodes des premier et deuxième amplificateurs déphaseurs ont leurs bases interconnectées et portées à un potentiel de référence Vref. A la paire différentielle de transistors d'entrée constituée des transistors T11 et T12 sont appliqués respectivement un signal I et un signal $\overline{I}$ qui sont complémentaires l'un de l'autre et déphasés de 45° par rapport à un signal de réception préamplifié. Aux bases de la paire différentielle de transistors d'entrée constituée par T21 et T22 sont appliquées respectivement les signaux $\overline{Q}$ et Q complémentaires, le signal Q étant déphasé de 135° par rapport au signal d'entrée préamplifié. Le signal de courant amplifié et déphasé correspondant au signal d'entrée I est appliqué à la résistance de charge RL1 ainsi que le signal amplifié et déphasé correspondant au signal d'entrée $\overline{Q}$. D'une manière analogue le signal amplifié et déphasé correspondant au signal d'entrée Q est appliqué à la résistance de charge RL2 ainsi que le signal de courant amplifié et déphasé correspondant au signal d'entrée $\overline{I}$.

Le circuit représenté à la figure 5 effectue donc une amplification des signaux d'entrée et une recombinaison après déphasage sur deux résistances de charge RL1 et RL2, faisant apparaître un signal différentiel de sortie VS, $\overline{VS}$ sur les bornes 51 et 52 connectées aux résistances de charge RL1 et RL2. Bien entendu, il est clair qu'une connexion inversée des sorties des amplificateurs déphaseurs sur les résistances de charge RL1 et RL2 est également possible, et ce, en fonction des circonstances d'utilisation.

Le schéma de la figure 5 présente également une variante de réalisation avantageuse consistant à permettre d'ajuster la valeur de déphasage de chacun des amplificateur déphaseur au moyen de résistances additionnelles RA connectables à volonté en parallèle sur les résistances de déphasage R11, R12, R21, R22, au moyen de transistors Tx jouant le rôle d'interrupteur, lesquels transistors sont de type à effet de champ MOS.

Pour des raisons de clarté, sur la figure 5 une seule résistance additionnelle RA à été représentée en parallèle sur chaque résistance de déphasage mais il est clair que l'on peut prévoir aisément plusieurs résistances connectables une par une ou par groupes au moyen de transistors interrupteurs recevant chacun une commande de commutation appropriée. Cette possibilité à été symbolisée sur la figure par les prolongements en pointillés des connexions aboutissant aux résistances de déphasage.

Pour de plus amples détails concernant le principe de réjection de la fréquence image, dans un appareil de réception, on peut se reporter à l'article "Microwave mixers" de S.A. MAAS, publié par Artech House Inc., Norwood, MA, USA -1993- International Standard Book n° 0 89006-605-1, p.279 à 285, incorporé par référence à la présente demande.

L'invention ne se limite pas aux exemples décrits précédemment. En premier lieu, le spécialiste comprendra aisément qu'un montage cascode est particulièrement adapté, vu sa simplicité, pour fournir une amplification de type transimpédance pour l'amplificateur déphaseur selon l'invention, mais que tout autre montage connu réalisant la même fonction de type transimpédance, peut lui être substitué sans différence notable de résultat.

D'autre part, les types des transistors utilisés peuvent être échangés, en particulier en ce qui concerne la polarité et le genre bipolaire ou à effet de champ. On notera également à propos de l'étage cascode formé des transistors T3 et T4 de la figure 1 ou transistors T31, T32, T41, T42, de la figure 5, qu'ils ont été décrits comme étant du même type que les transistors de la paire différentielle d'entrée des amplificateurs déphaseurs. Toutefois, selon une variante non représentée, un étage cascode dit "replié" peut également être utilisé en remplaçant les transistors en question par des transistors de la polarité opposée de sorte que les résistances de charge sont connectées par une extrémité à la tension de référence (masse), les émetteurs de ces transistors d'une part, étant couplés aux noeuds A, B, (A', B') et d'autre part recevant un courant à partir de la borne de tension d'alimentation Vcc via des sources de courant convenables.

## Revendications

1. Amplificateur déphaseur comprenant un premier et un deuxième transistors ($T_1$, $T_2$) agencés pour former une paire différentielle d'entrée alimentée à courant constant, ces transistors ayant chacun une électrode de commande ($I_1$, $I_2$) recevant un signal d'entrée, ainsi qu'une électrode de sortie, amplificateur dans lequel l'électrode de sortie du premier transistor est connectée à une borne d'une première résistance de déphasage (Rd1) ainsi qu'à une borne d'une première capacité de déphasage ($C_1$), l'électrode de sortie du deuxième transistor est connectée à une borne d'une deuxième résistance de déphasage (Rd2) ainsi qu'à une borne d'une deuxième capacité de déphasage ($C_2$), l'autre borne de la première résistance de déphasage est connectée à l'autre borne de la deuxième capacité de déphasage en un premier noeud (A); et l'autre borne de la deuxième résistance de déphasage est connectée à l'autre borne de la première capacité de déphasage en un deuxième noeud (B), caractérisé en ce que le premier noeud est connecté à l'entrée d'un amplificateur de type transimpédance et le deuxième noeud est connecté à l'entrée d'un autre amplificateur de type transimpédance, lesquels amplificateurs délivrent un signal différentiel de sortie déphasé par rapport au signal d'entrée.

2. Amplificateur déphaseur selon la revendication 1, caractérisé en ce que les amplificateurs de type transimpédance sont constitués par un étage cascode formé par un troisième, respectivement un quatrième transistors ($T_3$, $T_4$), dont les électrodes de sortie sont couplées respectivement à une première et à une deuxième résistance de charge ($R_{L1}$,

$R_{L2}$) et dont les électrodes de commande reçoivent une tension de référence.

3. Amplificateur déphaseur selon l'une des revendications 1 ou 2, caractérisé en ce qu'il comporte au moins une résistance de déphasage additionnelle ($R_A$), susceptible d'être connectée en parallèle sur chacune des résistance de déphasage au moyen d'un interrupteur électronique.

4. Amplificateur déphaseur selon la revendication 3, caractérisé en ce que l'interrupteur électronique est constitué par un transistor à effet de champ ($T_x$) de type MOS.

5. Amplificateur déphaseur selon l'une quelconque des revendications 2 à 4, caractérisé en ce que les premier, deuxième, troisième et quatrième transistors ($T_1$, $T_2$, $T_3$, $T_4$) sont des transistors bipolaires.

6. Circuit recombineur effectuant pour chacun de deux signaux différentiels d'entrée, déphasés l'un par rapport à l'autre, une amplification et une sommation de ces signaux après un déphasage complémentaire, l'un des signaux d'entrée présentant une première composante de phase déterminée et l'autre signal d'entrée présentant une deuxième composante en quadrature avec la première composante, caractérisé en ce qu'il est constitué de deux amplificateurs déphaseurs selon l'une des revendications 1 à 5.

7. Circuit recombineur selon la revendication 6, dans lequel lesdits amplificateurs de type transimpédance présentent une impédance de sortie non nulle, caractérisé en ce qu'une sortie de l'un de ces amplificateurs est directement connectée à une sortie de l'autre amplificateur.

## Claims

1. A phase shift amplifier comprising a first and a second transistor ($T_1$, $T_2$) arranged to form a differential input pair supplied with constant current, these transistors each having a control electrode ($I_1$, $I_2$) for receiving an input signal, and an output electrode, wherein the output electrode of the first transistor is connected to a terminal of a first phase shift resistor (Rd1) and also to a terminal of a first phase shift capacitor ($C_1$), the output electrode of the second transistor is connected to a terminal of a second phase shift resistor (Rd2) and also to a terminal of a second phase shift capacitor ($C_2$), the second terminal of the first phase shift resistor is connected to the second terminal of the second phase shift capacitor at a first node (A), and the second terminal of the second phase shift resistor is connected to the second terminal of the first phase shift capacitor at a second node (B), characterized in that the first node is connected to the input of an amplifier of the transimpedance type and the second node is connected to the input of a second amplifier of the transimpedance type, which amplifiers produce a differential output signal shifted in phase relative to the input signal.

2. A phase shift amplifier as claimed in Claim 1, characterized in that the amplifiers of the transimpedance type include a cascoded stage formed by a third and a fourth transistor ($T_3$, $T_4$), the output electrodes of which are coupled to a first and to a second load resistor ($R_{L1}$, $R_{L2}$) respectively, and the control electrodes of which receive a reference voltage.

3. A phase shift amplifier as claimed in either Claim 1 or Claim 2, characterized in that the phase shift amplifier comprises at least an additional phase shift resistor ($R_A$) which can be connected in parallel with each of the phase shift resistors by means of an electronic switch.

4. A phase shift amplifier as claimed in Claim 3, characterized in that the electronic switch includes a MOS-type field effect transistor ($T_x$).

5. A phase shift amplifier as claimed in any one of the Claims 2 to 4, characterized in that the first, second, third and fourth transistors ($T_1$, $T_2$, $T_3$, $T_4$) are bipolar transistors.

6. A recombining circuit performing for either one of the two differential input signals, phase shifted relative to each other, an amplification and a summation of these signals after a further phase shift, one of the input signals having a first component of a given phase and the other input signal having a second component having a quadrature phase relationship to the first component, characterized in that the recombining circuit includes two phase shift amplifiers as claimed in one of the Claims 1 to 5.

7. A recombining circuit as claimed in Claim 6, in which said amplifiers of the transimpedance type have a non-zero output impedance, characterized in that an output of one of these amplifiers is directly connected to an output of the other amplifier.

**Patentansprüche**

1. Phasenschiebverstärker mit einem ersten und zweiten Transistor (T1, T2), angeordnet, um ein differentiales Eingangspaar konstanten Stroms zu bilden, wobei diese Transistoren jeweils eine ein Eingangssignal erhaltende Steuerelektrode (I1, I2) und eine Ausgangselektrode haben, in dem Verstärker die Ausgangselektrode des ersten Transistors an die Klemme eines ersten Phasenschiebwiderstands (Rd1) sowie an die Klemme einer ersten Phasenschiebkapazität (C1) angeschlossen ist, die Ausgangselektrode des zweiten Transistors an eine Klemme eines zweiten Phasenschiebwiderstands (Rd2) sowie an die Klemme einer zweiten Phasenschiebkapazität (C2) angeschlossen ist, die andere Klemme des ersten Phasenschiebwiderstands an die andere Klemme der zweiten Phasenschiebkapazität an einem ersten Knoten (A) angeschlossen und die andere Klemme des zweiten Phasenschiebwiderstands an die andere Klemme der ersten Phasenschiebkapazität an einem zweiten Knoten (B) angeschlossen ist, dadurch gekennzeichnet, daß der erste Knoten an den Eingang eines Verstärkers vom Transimpedanztyp angeschlossen und der zweite Knoten an den Eingang eines anderen Verstärkers vom Transimpedanztyp angeschlossen ist, wobei diese Verstärker ein in bezug auf das Eingangssignal phasenverschobenes differentiales Ausgangssignal abgeben.

2. Phasenschiebverstärker nach Anspruch 1, dadurch gekennzeichnet, daß die Verstärker vom Transimpedanztyp von einer Kaskodenstufe in der Form eines dritten respektive vierten Transistors (T3, T4) gebildet werden, deren Ausgangselektroden respektive an einen ersten und einen zweiten Ladewiderstand (RL1, RL2) gekoppelt sind, deren Steuerelektroden eine Referenzspannung erhalten.

3. Phasenschiebverstärker nach einem der Ansprüche 1 oder 2 dadurch gekennzeichnet, daß er mindestens einen zusätzlichen Phasenschiebwiderstand (RA) enthält, der mit einem elektronischen Schalter parallel zu jedem der Phasenschiebwiderstände angeschlossen werden kann.

4. Phasenschiebverstärker nach Anspruch 3, dadurch gekennzeichnet, daß der elektronische Schalter von einem Feldeffekttransistor vom Typ MOS gebildet wird.

5. Phasenschiebverstärker nach einem beliebigen der Ansprüche 2 bis 4 dadurch gekennzeichnet, daß der erste, zweite, dritte und vierte Transistor (T1, T2, T3, T4) Bipolartransistoren sind.

6. Zusammenführschaltung, die für jedes der beiden differentialen Eingangssignale, das eine in bezug auf das andere phasenverschoben, eine Verstärkung und eine Summation dieser Signale nach zusätzlicher Phasenverschiebung vornimmt, wobei eines der Eingangssignale eine erste bestimmte Phasenkomponente und das andere Eingangssignal eine zweite Komponente bildet, zur ersten Komponente um 90° phasenverschoben, dadurch gekennzeichnet daß er von zwei Phasenschiebverstärkern nach einem der Ansprüche 1 bis 5 gebildet wird.

7. Zusammenführschaltung nach Anspruch 6, in der die besagten Verstärker vom Transimpedanztyp eine Ausgangsimpedanz ungleich Null aufweisen, dadurch gekennzeichnet, daß einer dieser Verstärker direkt an den Ausgang des anderen Verstärkers angeschlossen ist.

FIG. 1

FIG. 2

FIG. 3

FIG. 4

FIG. 5